# EUROPEAN PATENT APPLICATION

(11) **EP 3 190 119 A1**
(43) Date of publication of application: **12.07.2017**
(21) Application number: 16182165.7
(22) Date of filing: 01.08.2016
(51) Int. Cl.: C07F 9/6593, C08K 5/5399

(54) **PHOSPHAZENE COMPOUND COMPRISING CYANO GROUP, PREPARATION METHOD AND USES THEREOF**

(30) Priority: 07.01.2016 CN 201610012162
(71) Applicant: Guangdong Guangshan New Materials Co., Ltd., Guangdong 523000 (CN)
(72) Inventor: PAN, Qingchong, Guangdong 523000 (CN)
(74) Representative: Agasse, Stéphane

(57) **Abstract**

The present invention relates to a phosphazene compound comprising cyano group having a molecular structure of Formula (I); wherein, Y and Y' are independently selected from organic groups; M₁ and M₂ are independently selected from phosphazene groups, and M₁ contains m₁ phosphorus atoms, and M₂ contains m₂ phosphorus atoms; X₁, X₁', X₂, X₃ and X₄ are independently selected from any one of the sixth main-group elements; R and R' are independently selected from divalent organic groups; a is an integer greater than or equal to 0; b is an integer greater than or equal to 1; and c is an integer greater than or equal to 0; and a+b=2m₁, d+2=2m₂. The present invention achieves a synergistic effect with P and N of phosphazene group by introducing cyano group to the phosphazene group, and thus improves thermal stability and flame retardancy of the phosphazene compound, and the compatibility thereof with other components is excellent. The resin composition comprising the phosphazene compound of the present invention has good heat resistance, water resistance, adhesive properties and mechanical properties, and thus the application thereof is widened.

## Description

### Technical field

The present invention belongs to the technical field of flame retardant materials, in particular relates to a phosphazene compound comprising cyano group, a preparation method and uses thereof.

### Background art

For the purpose of safety, electronic products represented by mobile phones, computers, video cameras and electronic game machines, household and office electrical products represented by air conditioners, refrigerators, television images, audio products etc., and various products used in other areas require different degrees of flame retardancy.

In order to make the products achieve required flame retardant performance or grade, traditional techniques often utilize the following means: adding inorganic flame retardant materials such as types of metal hydroxides comprising crystal water, for example, aluminum hydroxide hydrate, magnesium hydroxide hydrate, and others, into a material system; and adding organic chemicals having a high content of bromine or halogen, such as brominated bisphenol A, brominated bisphenol A epoxy resin and others into a material system. In order to improve the flame retardancy of these organic chemicals containing halogen, environmentally unfriendly inorganic chemical flame retardants such as antimony trioxide and others are often added into the system.

Due to the use of flame retardant materials containing halogen, it can produce toxic substances which cannot degrade or is difficult to degrade such as dioxin type organic halogen chemicals when burning, and those toxic substances pollute the environment and affect health of humans and animals.

For the purpose of protecting the environment, the flame retardant effect is achieved by using halogen-free compounds containing phosphorous and/or nitrogen and others as flame retardants to replace halogen-containing compounds, especially in the electronic, electrical and electronic appliances industries, using reactive mono-functional (which means that there is only one active reactive group in one molecule) 9,10-dihydro-9-oxa-10-phosphaphenanthrene-10-oxide (hereinafter referred to as DOPO simply), more often derivatives of DOPO as a flame retardant component, with or without adding aluminum hydroxide hydrate and magnesium hydroxide hydrate.

In the electronic field, the reaction products (abbreviated as DOPO epoxy resin) of DOPO and high-cost, multifunctional epoxy resin, such as linear phenolic epoxy resin, o-methyl phenolic epoxy resin and bisphenol A phenolic epoxy resin are widely applied as the epoxy resin material for copper-clad laminate use.

The copper-clad laminates produced by using DOPO epoxy resin have good flame retardancy. However, they have many defects in cohesiveness, heat-resistance and processability, and thus cannot meet the demand of high multilayer, high reliability, high cohesiveness and good processability for manufacturing modem communications. In addition, due to high cost, it is disadvantageous for them to spread to the civilian goods field such as consumer electronics demanding low-cost consumption, for example cell phones.

In the electronic field, DOPO reacts with, such as, etherates of bisphenol A, bisphenol F, phenolic resin, phenol and o-cresol, to produce a phenol-containing compound containing DOPO skeleton (collectively called phosphorous-containing phenolic resin) which is used as a curing agent for epoxy resins or an additive for flame retardant materials, and as a flame retardant for epoxy resin materials for copper-clad laminate use.

The copper-clad laminates produced by using phosphorous-containing phenolic aldehyde as a part of or all of the flame retardant ingredients can achieve flame retardancy. However, there are many defects in acid/base resistance, chemical resistance, cohesiveness, heat resistance, processability and so on, so that they cannot meet the demand of high multilayer, high reliability, high cohesiveness and good processability for manufacturing modem communications. In addition, due to high cost, it is disadvantageous for them to spread to the civilian goods field such as consumer electronics demanding low-cost consumption, for example cell phones.

With the factors such as improvement of the electronic industry towards demands of short, small, thin, high multilayer and high reliability, and popularization of civilian consumer electronics, and pressure of more and more serious environmental pollution, there is an urgent market demand for cheap flame retardant substances having good flame retardancy, heat resistance and good mechanical properties.

### Contents of the Invention

Aiming at the problems in the prior art, one of the objects of the present invention lies in providing a phosphazene compound comprising cyano group, which has a structure of formula (I): 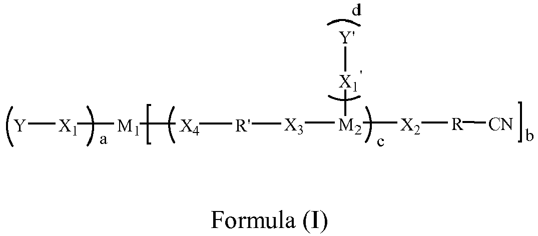
wherein, Y and Y' are independently selected from organic groups;
M₁ and M₂ are independently selected from phosphazene groups, and M₁ contains m₁ phosphorus atoms, and M₂ contains m₂ phosphorus atoms;
X₁, X₁', X₂, X₃ and X₄ are independently selected from any one of the sixth main-group elements;
R and R' are independently selected from divalent organic groups;
a is an integer greater than or equal to 0; b is an integer greater than or equal to 1; and c is an integer greater than or equal to 0; and a+b=2m₁, d+2=2m₂. According to the different ratios of phosphorus atoms in M₁ and M₂, the values of a, b, c and d are different, as long as they meet the formulas of a+b=2m₁ and d+2=2m₂.

In formula (I), M₁ and M₂ are the same or different phosphazene groups. The M₁ and M₂ in the present invention are independently selected from cyclic phosphazene having a structure of formula (II) or linear phosphazene having a structure of formula (III); 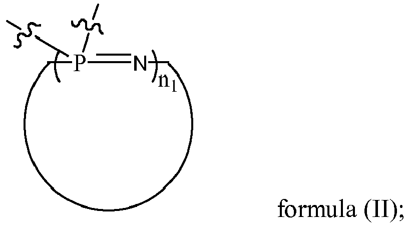 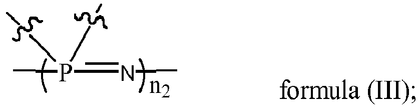 in formula (II) or formula (III), n₁ is an integer greater than or equal to 2, and n₂ is an integer greater than or equal to 1;
preferably any one of cyclotriphosphazene, cyclotetraphosphazene or non-cyclic polyphosphazene, or a combination of at least two of them; preferably cyclotriphosphazene;

It should be noted that the structure 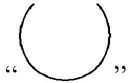 in the structural formulas of M₁ and M₂ is only a representation of cyclic structure.

Preferably, Y and Y' are independently selected from the group consisting of substituted or unsubstituted straight chain alkyl, substituted or unsubstituted branched alkyl, or substituted or unsubstituted aryl; preferably C₁-C₃₀ substituted or unsubstituted straight chain alkyl, C₁-C₃₀ substituted or unsubstituted branched alkyl, or C₆-C₃₀ substituted or unsubstituted aryl; further preferably C₁-C₁₀ substituted or unsubstituted straight chain alkyl, C₁-C₁₀ substituted or unsubstituted branched alkyl, or C₆-C₁₆ substituted or unsubstituted aryl; in particular preferably phenyl, tolyl, xylyl, ethylphenyl, methyl, ethyl, n-propyl, n-butyl, isopropyl, or isobutyl.

Further preferably, Y and Y' are independently phenyl, tolyl, xylyl or ethylphenyl.

Here, it can be understood that Y and Y' are phenyl, in many cases.

Preferably, R and R' are independently selected from the group consisting of substituted or unsubstituted straight chain alkylene, substituted or unsubstituted branched alkylene, and substituted or unsubstituted arylene; preferably C₁-C₃₀ substituted or unsubstituted straight chain alkylene, C₁-C₃₀ substituted or unsubstituted branched alkylene, and C₆-C₃₀ substituted or unsubstituted arylene; further preferably C₁-C₁₀ substituted or unsubstituted straight chain alkylene, C₁-C₁₀ substituted or unsubstituted branched alkylene, and C₆-C₁₆ substituted or unsubstituted arylene; in particular preferably phenylene, methylphenylene, dimethylphenylene, ethylphenylene, 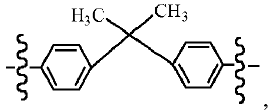 methylene, ethylene, propylene, 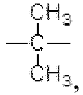 n-butylene, or isopropylene.

Further preferably, R and R' are independently phenylene, methylphenylene, dimethylphenylene, ethylphenylene, or

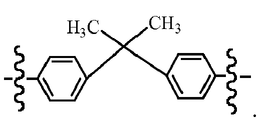

Here, it can be understood that R is phenylene, in many cases.

Here, it can be understood that R' is phenylene or 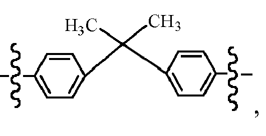 in many cases.

Preferably, each X₁, X₁', X₂, X₃ and X₄ is O.

The phosphazene compound of the present invention is preferably 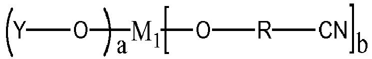 or 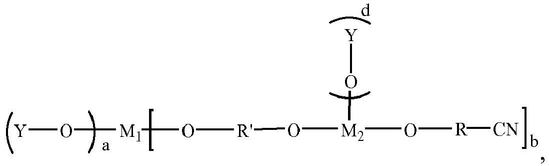 wherein each M₁, M₂, a, b, R and R' has the same selection scopes as that in claim 1.

Preferably, the phosphazene compound is selected from the group consisting of 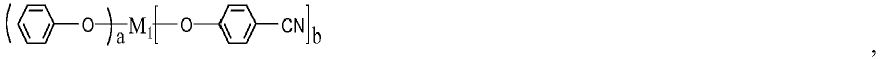 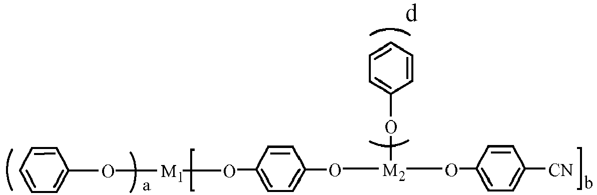 or 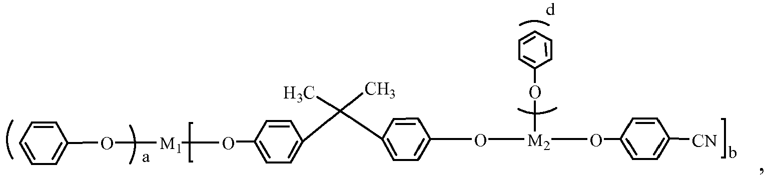 wherein each M₁, M₂, a and b has the same selection scopes as that in claim 1.

Preferably, the phosphazene compound is selected from 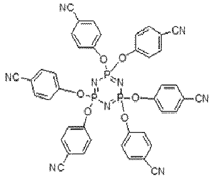 or

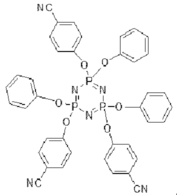

In the present invention, the chemical bond 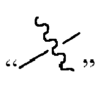 is a broken bond, which can be connected to anther broken bond to form a complete chemical bond, making two groups connected according to the formula structure, or it is directly connected to a certain position of phenyl by breaking bond.

The term "substituted" in the present invention means that any one or more hydrogen atoms on a particular atom are substituted by substituents of particular groups, on condition that the particular atom does not exceed normal valence state, and the substituted result is to produce stable compounds. When the substituent is oxo group or ketone group (i.e. =O), the two hydrogen atoms on atoms are substituted. Ketone substituents do not exist on aromatic rings. "Stable compound" means compounds which can be separated robustly enough to effective purity from reaction mixture and prepared to effective compounds.

The present invention also provides a method for preparing the previous phosphazene compound comprising cyano group, comprising the step of carrying out a nucleophilic substitution reaction of phosphazene chloride and a first raw material compound.

The phosphazene chloride is M₁(Cl)ₚ and/or M₂(Cl)_{q}, p=2m₁, and q=2m₂.

The first raw material compound is any one of Y-X₁-H, Y'-X₁'-H, H-X₂-R-CN or H-X₄-R'-X₃-H, or a combination of at least two of them. The first raw material compound must comprise H-X₂-R-CN or H-X₄-R'-X₃-H. Wherein, each X₁, X₁', X₂, X₃, X₄, Y, Y', R and R' has the same meaning as that in any one of claims 1-3, and R, R', Y and Y' are preferably substituted or unsubstituted phenyl, further preferably unsubstituted phenyl.

Alternatively, the first raw material compound is any one of Y X₁-Na, Y'-X₁'-Na, 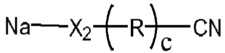 or Na-X₄-R'-X₃-Na, or a combination of at least two of them.

The raw material compound must comprise 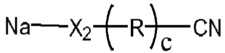 or Na-X₄-R'-X₃-Na. Wherein, each X₁, X₁', X₂, X₃, X₄, Y, Y', R and R' has the same meaning as previously mentioned.

The nucleophilic substitution reaction can be carried out by methods well-known in the art, for example "Research Advances in the Preparation of Polyphosphazene, Hongwei ZHANG et al, Materials Review, 2010, volume 24, issue 7". Specific examples of catalysts are metal chlorides such as zinc chloride, magnesium chloride, aluminum chloride; boron trifluoride and complexes thereof; Lewis bases such as sodium hydroxide. These catalysts may be used alone or in combination, which is not specially defined in the present invention. Hexachlorocyclotriphosphazene of which the source is the most extensive and others can be used as phosphazene chloride. In order to obtain the Y-X₁-, Y'-X₁'-, 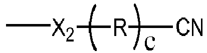 and -X₄-R'-X₃- groups in the target product, a nucleophile which can provide Y-X₁-, Y'-X₁'-, 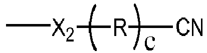 and -X₄-R'-X₁- groups can be added at the same time, or respectively and successively.

In the reaction of nucleophile and phosphazene chloride, a nucleophile can be firstly utilized to react with phosphazene chloride to partially substitute chlorine atom(s) in phosphazene chloride, and then another nucleophile is utilized to react with the phosphazene chloride to obtain the phosphazene compound of formula (I). In addition, a phosphazene compound comprising one or more M groups in its structure can be obtained by controlling the relationship of amount of these materials.

The present invention also provides a cyanate ester resin composition comprising the previous phosphazene compound comprising cyano group.

The cyanate ester resin composition of the present invention has good flame retardancy, heat resistance (resistant to a high temperature of 200°C), good adhesive properties and good mechanical properties.

Cyanate ester resin, curing agent and other fillers of the cyanate ester resin composition can utilize well-known materials in the art.

The present invention also provides a prepreg prepared by impregnating a substrate with the cyanate ester resin composition or coating the cyanate ester resin composition onto a substrate.

The substrate can be a glass fiber substrate, a polyester substrate, a polyimide substrate, a ceramic substrate or a carbon fiber substrate.

Here, the specific process conditions of impregnation or coating are not particularly limited. The "prepreg" is "bonding sheet" well-known by those skilled in the art.

A composite metal laminate comprising more than one sheet of the prepreg described above and prepared by coating metal layer on the surface of the prepregs, overlapping and pressing successively.

Here, the material of the surface-coated metal layer is aluminium, copper, iron and alloys of any combination thereof.

Specific examples of the composite metal laminate are CEM-1 copper-clad laminate, CEM-3 copper-clad laminate, FR-4 copper-clad laminate, FR-5 copper-clad laminate, CEM-1 aluminum-clad laminate, CEM-3 aluminum-clad laminate, FR-4 aluminum-clad laminate or FR-5 aluminum-clad laminate.

The present invention also provides a wiring board prepared by processing wirings on the surface of the composite metal laminate as described above.

The present invention also provides a flexible copper-clad laminate, which comprises at least one prepreg as mentioned above and a copper foil overlaying at one side or both sides of the superimposed prepregs.

The present invention also provides a use of the phosphazene compound comprising cyano group, which is used in IC package panel, HDI package panel, automotive panel or copper-clad laminate

The raw materials of the cyanate ester resin composition are cured on the composite metal laminate to form coatings having good flame retardancy, and this can improve the wide use of the wiring board in industries of machine, equipment, instrument, meter, etc., which need wiring board, for example electronic industry, electrical and electrical appliance industry, transportation industry, aerospace industry, toy industry, etc.

The above term "xxxyl or group" refers to the remaining parts of the molecular structure of corresponding compounds after one or more hydrogen atoms or other atoms or atomic groups are removed.

The present invention achieves a synergistic effect with P and N of phosphazene group by introducing cyano group to the phosphazene group, and thus improves thermal stability and flame retardancy of the phosphazene compound, and the compatibility thereof with other components is excellent. The resin composition comprising the phosphazene compound of the present invention has good heat resistance, water resistance, adhesive properties, mechanical properties, and electrical properties, and thus the application thereof is widened. The flame retardant grade of the epoxy resin prepared by using the phosphazene compound provided by the present invention can achieve V-0.

### Embodiments

The technical solutions of the present invention are further described by the following embodiments.

Those skilled in the art should appreciate that the embodiments only help understand the present invention and shall not be deemed as limitations to the present invention.

### Example 1

Aphosphazene compound 1 having the following structure:

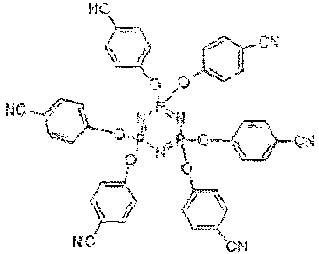

The preparation method thereof is as follow:
(1) in a reactor, 714 g (6 eq) of p-cyanophenol with a hydroxyl equivalent of 119 g/eq was dissolved into dioxane, and then 170.5 g (6 eq) of hexachlorocyclotriphosphazene with a chlorine atom equivalent of 28.4 g/eq and 318 g (6 eq) of sodium carbonate with a sodium atom equivalent of 53 g/eq were added therein, and the mixture was reacted for 24 hours at a reflux temperature under nitrogen protection;
(2) the salts and water in the system of the product obtained in step (1) were removed by physical method; the insoluble substance in the system was removed by filtration; and the solvent in the system was distilled off; and the phosphazene compound 1 with a cyano group equivalent of 140.7 g/eq was obtained after drying.

### Characterizations:

Infrared Spectroscopy: 1400-1600cm⁻¹ (benzene ring); 2220-2230cm⁻¹ (cyano group); 1260-1280cm⁻¹ (P-N); 1170-1185 cm⁻¹ (P=N); 955-960cm⁻¹, 1005-1015cm⁻¹, 1065-1075cm⁻¹ (P-O-C); in addition, the peak at 510 cm⁻¹ (P-Cl) is disappeared;
Nuclear Magnetic Resonance ¹H-NMR (DMSO-d6, ppm): 6.85-6.95 (hydrogen at an ortho-position to phenolic hydroxyl in cyanophenol group,12H), 7.3-7.4(hydrogen at an meta-position to phenolic hydroxyl in cyanophenol group, 12H).

### Example 2

Aphosphazene compound 2 having the following structure:

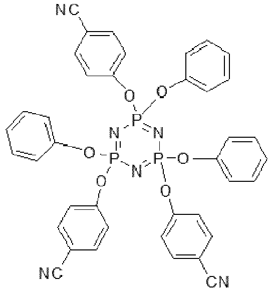

The preparation method thereof is as follow:
(1) in a reactor, 357 g (3 eq) of p-cyanophenol with a hydroxyl equivalent of 119 g/eq and 282 g (3 eq) of phenol with a hydroxyl equivalent of 94 g/eq were dissolved into dioxane, and then 170.5 g (6 eq) of hexachlorocyclotriphosphazene with a chlorine atom equivalent of 28.4g/eq and 318 g (6 eq) of sodium carbonate with a sodium atom equivalent of 53 g/eq were added therein, and the mixture was reacted for 24 hours at a reflux temperature under nitrogen protection;
(2) the product obtained in step (1) was washed by alkali, and then the residual materials were removed, and the phosphazene compound 2 with a cyano group equivalent of 256.2 g/eq was obtained after drying.

### Characterizations:

Infrared Spectroscopy: 1400-1600cm⁻¹ (benzene ring); 2220-2230cm⁻¹ (cyano group); 1260-1280cm⁻¹ (P-N); 1170-1185 cm⁻¹ (P=N); 955-960cm⁻¹, 1005-1015cm⁻¹, 1065-1075cm⁻¹ (P-O-C); in addition, the peak at 510 cm⁻¹ (P-Cl) is disappeared;
Nuclear Magnetic Resonance ¹H-NMR (DMSO-d6, ppm): 6.85-6.95 (hydrogen at an ortho-position to phenolic hydroxyl in cyanophenolichydroxyl, 6H), 7.3-7.4(hydrogen at an ortho-position to cyano group in cyanophenolichydroxyl, 6H), 6.73 (hydrogen at an ortho-position to phenolic hydroxyl in phenol group, 6H), 7.05-7.12 (hydrogen at an meta-position to phenolic hydroxyl in phenol group, 6H), 6.80-6.84 (hydrogen at an para-position to phenolic hydroxyl in phenol group, 3H).

### Example 3

Aphosphazene compound 3 having the following structure:

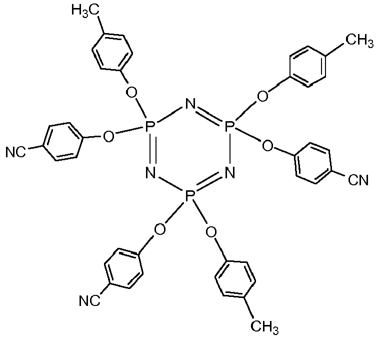

The preparation method thereof is as follow:
(1) in a reactor, 357 g (3 eq) of p-cyanophenol with a hydroxyl equivalent of 119 g/eq and 324 g (3 eq) of para-methylphenol with a hydroxyl equivalent of 108 g/eq were dissolved into dioxane, and then 170.5 g (6 eq) of hexachlorocyclotriphosphazene with a chlorine atom equivalent of 28.4g/eq and 318 g (6 eq) of sodium carbonate with a sodium atom equivalent of 53 g/eq were added therein, and the mixture was reacted for 24 hours at a reflux temperature under nitrogen protection;
(2) the product obtained in step (1) was washed by alkali, and then the residual materials were removed, and the phosphazene compound 3 with a cyano group equivalent of 270 g/eq was obtained after drying.

### Characterizations:

Infrared Spectroscopy: 1400-1600cm⁻¹ (benzene ring); 2220-2230cm⁻¹ (cyano group); 1260-1280cm⁻¹ (P-N); 1170-1185 cm⁻¹ (P=N); 955-960cm⁻¹, 1005-1015cm⁻¹, 1065-1075cm⁻¹ (P-O-C); 2960 cm⁻¹, 2870 cm⁻¹ (methyl); in addition, the peak at 510 cm⁻¹ (P-Cl) is disappeared;

Nuclear Magnetic Resonance ¹H-NMR (DMSO-d6, ppm): 6.85-6.95 (hydrogen at an ortho-position to phenolic hydroxyl in cyanophenolichydroxyl, 6H), 7.3-7.4(hydrogen at an ortho-position to cyano group in cyanophenolichydroxyl, 6H), 6.73 (hydrogen at an ortho-position to phenolic hydroxyl in phenol group, 6H), 7.05-7.12 (hydrogen at an meta-position to phenolic hydroxyl in phenol group, 6H), 6.80-6.84 (hydrogen at an para-position to phenolic hydroxyl in phenol group, 3H), 2.3-2.4 (hydrogen in methyl, 9H).

### Example 4

A phosphazene compound 4 having the following structure:

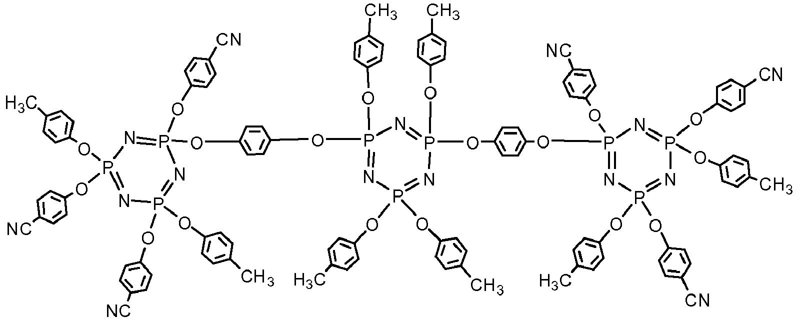

There preparation method thereof is as follow:
(1) in a reactor, 357 g (3 eq) of p-cyanophenol with a hydroxyl equivalent of 119 g/eq, 216 g (2 eq) of para-methylphenol with a hydroxyl equivalent of 108 g/eq and 110 g (2 eq) of hydroquinone with a hydroxyl equivalent of 55 g/eq were dissolved into dioxane, and then 170.5 g (6 eq) of hexachlorocyclotriphosphazene with a chlorine atom equivalent of 28.4g/eq and 318 g (6 eq) of sodium carbonate with a sodium atom equivalent of 53 g/eq were added therein, and the mixture was reacted for 24 hours at a reflux temperature under nitrogen protection;
(2) 170.5 g (6 eq) of hexachlorocyclotriphosphazene with a chlorine atom equivalent of 28.4g/eq, 432 g (4 eq) of para-methylphenol with a hydroxyl equivalent of 108 g/eq, 110 g (2 eq)of hydroquinone with a hydroxyl equivalent of 55 g/eq and 318 g (6 eq) of sodium carbonate with a sodium atom equivalent of 53 g/eq were added into the product obtained in step (1), and the mixture was reacted for 24 hours at a reflux temperature under nitrogen protection;
(3) 170.5 g (6 eq) of hexachlorocyclotriphosphazene with a chlorine atom equivalent of 28.4g/eq, 357 g (3 eq) of para-cyanophenol with a hydroxyl equivalent of 119 g/eq, 216 g (2 eq) of para-methylphenol with a hydroxyl equivalent of 108 g/eq, and 318 g (6 eq) of sodium carbonate with a sodium atom equivalent of 53 g/eq were added into the product obtained in step (2), and the mixture was reacted for 24 hours at a reflux temperature under nitrogen protection;
(4) the product obtained in step (3) was washed by alkali, and then the residual materials were removed, and the phosphazene compound 4 with a cyano group equivalent of 364.5 g/eq was obtained after drying.

### Characterizations:

Infrared Spectroscopy: 1400-1600cm⁻¹ (benzene ring); 2220-2230cm⁻¹ (cyano group); 1260-1280cm⁻¹ (P-N); 1170-1185 cm⁻¹ (P=N); 955-960cm⁻¹, 1005-1015cm⁻¹, 1065-1075cm⁻¹ (P-O-C); 2960 cm⁻¹, 2870 cm⁻¹ (methyl); in addition, the peak at 510 cm⁻¹ (P-Cl) is disappeared;

Nuclear Magnetic Resonance ¹H-NMR (DMSO-d6, ppm): 6.85-6.95 (hydrogen at an ortho-position to phenolic hydroxyl in cyanophenolichydroxyl, 20H), 7.3-7.4 (hydrogen at an ortho-position to cyano group in cyanophenolichydroxyl, 20H), 6.58-6.63 (hydrogen at an ortho-position to hydroxyl in para-methylphenol group, 8H), 6.85-6.95 (hydrogen at an ortho-position to methyl in para-methylphenol group, 8H), 2.3-2.4 (hydrogen in methyl, 30H).

### Application Example 1

A halogen-free flame retardant cyanate ester resin composition comprising the following components by weight parts:
22.5 g of the phosphazene compound 1 obtained in Example 1 and 88.2 g of phenolic resin with a phenolic hydroxyl equivalent of 105 were added into 187 g of liquid bisphenol A epoxy resin, and the mixture was dissolved into solution using an appropriate amount of acetone. A copper-clad laminate was obtained by using standard glass cloths, sizing and pressing. The obtained copper-clad laminate is named as copper-clad laminate a and the properties thereof are shown in table 1.

### Application Example 2

A halogen-free flame retardant cyanate ester resin composition comprising the following components by weight parts:
25.6 g of the phosphazene compound 1 obtained in Example 1 and 94.5 g of phenolic resin with a phenolic hydroxyl equivalent of 105 were added into 187 g of liquid bisphenol A epoxy resin, and the mixture was dissolved into solution using an appropriate amount of acetone. A copper-clad laminate was obtained by using standard glass cloths, sizing and pressing. The obtained copper-clad laminate is named as copper-clad laminate b and the properties thereof are shown in table 1.

### Application Example 3

A halogen-free flame retardant cyanate ester resin composition comprising the following components by weight parts:
27 g of the phosphazene compound 1 obtained in Example 1 and 94.5 g of phenolic resin with a phenolic hydroxyl equivalent of 105 were added into 187 g of liquid bisphenol A epoxy resin to obtain cyanate ester resin C, which was dissolved into solution using an appropriate amount of acetone. A copper-clad laminate was obtained by using standard glass cloths, sizing and pressing. The obtained copper-clad laminate is named as copper-clad laminate c and the properties thereof are shown in table 1.

### Application Example 4

A halogen-free flame retardant cyanate ester resin composition comprising the following components by weight parts:
29.15 g of the phosphazene compound 1 obtained in Example 1 and 96.6 g of phenolic resin with a phenolic hydroxyl equivalent of 105 were added into 187 g of liquid bisphenol A epoxy resin to obtain cyanate ester resin D, which was dissolved into solution using an appropriate amount of acetone. A copper-clad laminate was obtained by using standard glass cloths, sizing and pressing. The obtained copper-clad laminate is named as copper-clad laminate d and the properties thereof are shown in table 1.

### Comparative Example 1

The difference of Comparative Example 1 from Application Example 1 lies in: the phosphazene compound 1 was replaced with hexaphenoxylcyclotriphosphazene based on the same quality, and an epoxy resin composition E was obtained.

The epoxy resin composition E was dissolved into solution using an appropriate amount of acetone. A copper-clad laminate was obtained by using standard glass cloths, sizing and pressing. The obtained copper-clad laminate is named as copper-clad laminate e and the properties thereof are shown in table 1.

The tested results of products of Examples and Comparison Examples are shown in Table-1 below.

**Table 1 Comparison of properties of each copper-clad laminate**

| Test Item | Copper-clad laminate a | Copper-clad laminate b | Copper-clad laminate c | Copper-clad laminate d | Copper-clad laminate e |
|---|---|---|---|---|---|
| Tg (DSC) (°C) | 245 | 218 | 248 | 250 | 142 |
| Peeling strength (N·mm⁻¹) | 2.21 | 2.30 | 2.34 | 2.37 | 1.52 |
| Combustibilit y (UL-90) | V0 | V0 | V0 | V0 | V0 |
| Water absorption (%) | 0.32 | 0.31 | 0.25 | 0.22 | 0.52 |
| Bending strength (at room temperature) | 600 | 620 | 640 | 680 | 490 |
| (MPa, in longitudinal direction) | | | | | |
| Bending strength (180°C) (MPa, in longitudinal direction) | 540 | 580 | 570 | 590 | 100 |
| Average coefficient of linear expansion (50-250°C) (10⁻⁶/°C) | 2.3 | 2.2 | 2.2 | 2.2 | 2.8 |

Test methods for the above characteristics are as follows:

### (1) Water absorption

A 100mm×100mm×1.6mm board was placed in an oven at 105 °C to dry for 1 h, and was weighted after cooling and then steamed under a vapor pressure of 105kPa for 120 min, and finally wiped and weighted, and then the water absorption thereof was calculated.

### (2) Glass transition temperature Tg

A sample with a width of about 8-12 mm and a length of 60 mm was prepared and the glass transition temperature Tg thereof was measured on NETZSCH DMA Q800 by setting the measurement mode as bending mode and the scanning temperature as from room temperature to 200°C, and by reading the corresponding temperature at which the loss tangent value was maximum.

### (3) Bending strength

A 25.4mm×63.5mm sample was prepared, and the thickness thereof was measured using a vernier caliper, and the bending strength thereof were measured on universal material testing machine by adjusting the test mode as bending test mode, the space as 15.9 mm, and the test speed as 0.51 mm/min. An average value of three parallel tests was taken, and the test temperature was room temperature and 180°C respectively.

### (4) Peeling strength

The copper-clad laminate was cut into a 100mm×3mm test piece. The peeling strength of copper foil and resin was measured by stripping the copper foil and delaminating it at a speed of 50.8 mm/min using peeling resistance test device. A larger value represents a better adhesive force between resin and copper foil.

### (5) Combustibility

The combustibility was tested according to standard ANSL UL94-1985.

### (6) Coefficient of linear expansion

The coefficient of linear expansion was tested according to standard GB 5594.3-1985.

The applicant states that, the present invention describes the detailed technological process by the aforesaid examples, but the present invention is not limited by the aforesaid detailed technological process. That is to say, it does not mean that the present invention cannot be fulfilled unless relying on the aforesaid detailed technological steps. Those skilled in the art shall know that, any modification to the present invention, any equivalent replacement of each raw material of the product of the present invention and the addition of auxiliary ingredient, the selection of specific embodiment and the like all fall into the protection scope and the disclosure scope of the present invention.

## Claims

1. A phosphazene compound comprising cyano group, having a molecular structure as shown in Formula (I): 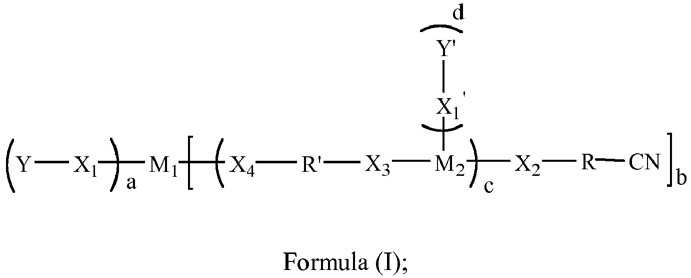
wherein, Y and Y' are independently selected from organic groups;
M₁ and M₂ are independently selected from phosphazene groups, and M₁ contains m₁ phosphorus atoms, and M₂ contains m₂ phosphorus atoms;
X₁, X₁', X₂, X₃ and X₄ are independently selected from any one of the sixth main-group elements;
R and R' are independently selected from divalent organic groups;
a is an integer greater than or equal to 0; b is an integer greater than or equal to 1; and c is an integer greater than or equal to 0; and a+b=2m₁, d+2=2m₂.

2. The phosphazene compound of claim 1, wherein M₁ and M₂ are independently selected from cyclic phosphazene having a structure of formula (II) or linear phosphazene having a structure of formula (III); 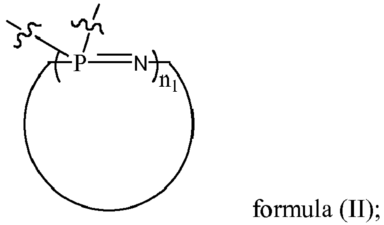 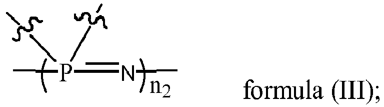
in formula (II) or formula (III), n₁ is an integer greater than or equal to 2, and n₂ is an integer greater than or equal to 1;
preferably any one of cyclotriphosphazene, cyclotetraphosphazene or non-cyclic polyphosphazene, or a combination of at least two of them; preferably cyclotriphosphazene;
preferably, Y and Y' are independently selected from the group consisting of substituted or unsubstituted straight chain alkyl, substituted or unsubstituted branched alkyl, or substituted or unsubstituted aryl; preferably C₁-C₃₀ substituted or unsubstituted straight chain alkyl, C₁-C₃₀ substituted or unsubstituted branched alkyl, or C₆-C₃₀ substituted or unsubstituted aryl; further preferably C₁-C₁₀ substituted or unsubstituted straight chain alkyl, C₁-C₁₀ substituted or unsubstituted branched alkyl, or C₆-C₁₆ substituted or unsubstituted aryl; in particular preferably phenyl, tolyl, xylyl, ethylphenyl, methyl, ethyl, n-propyl, n-butyl, isopropyl, or isobutyl;
further preferably, Y and Y' are independently phenyl, tolyl, xylyl or ethylphenyl;
preferably, R and R' are independently selected from the group consisting of substituted or unsubstituted straight chain alkylene, substituted or unsubstituted branched alkylene, and substituted or unsubstituted arylene; preferably C₁-C₃₀ substituted or unsubstituted straight chain alkylene, C₁-C₃₀ substituted or unsubstituted branched alkylene, and C₆-C₃₀ substituted or unsubstituted arylene;
further preferably C₁-C₁₀ substituted or unsubstituted straight chain alkylene, C₁-C₁₀ substituted or unsubstituted branched alkylene, and C₆-C₁₆ substituted or unsubstituted arylene; in particular preferably phenylene, methylphenylene, dimethylphenylene, ethylphenylene, 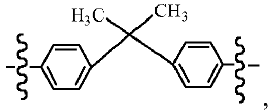 methylene, ethylene, propylene, 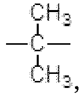 n-butylene, or isopropylene;
further preferably, R and R' are independently phenylene, methylphenylene, dimethylphenylene, ethylphenylene, or 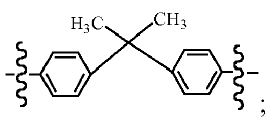
preferably, each X₁, X₁', X₂, X₃ and X₄ is O.

3. The phosphazene compound of claim 1 or 2, wherein the phosphazene compound is selected from 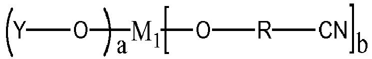 or 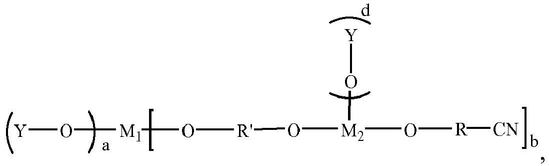 wherein each M₁, M₂, a, b, R and R' has the same selection scopes as that in claim 1; preferably, the phosphazene compound is selected from the group consisting of 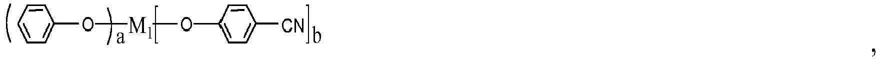 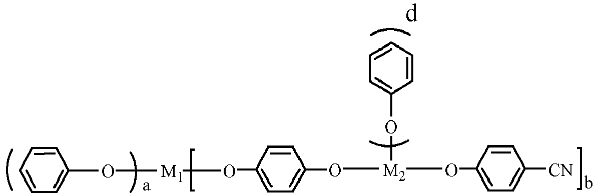 or 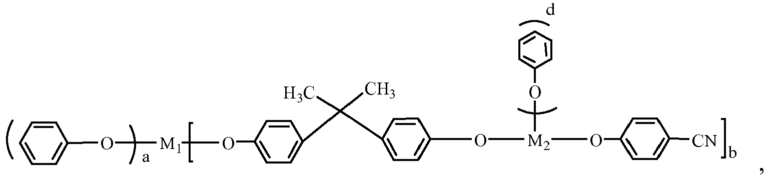 wherein each M₁, M₂, a and b has the same selection scopes as that in claim 1; preferably, the phosphazene compound is selected from 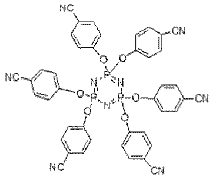 or

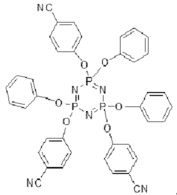

4. A method for preparing the phosphazene compound comprising cyano group of any one of claims 1-3, comprising the step of carrying out a nucleophilic substitution reaction of phosphazene chloride and a first raw material compound;
the phosphazene chloride is M₁(Cl)ₚ and/or M₂(Cl)_{q}, p=2m₁, and q=2m₂;
the first raw material compound is any one of Y X₁-H, Y'-X₁'-H, H-X₂-R-CN or H-X₄-R'-X₃-H, or a combination of at least two of them; the first raw material compound must comprise H-X₂-R-CN or H-X₄-R'-X₃-H; wherein, each X₁, X₁', X₂, X₃, X₄, Y, Y', R and R' has the same meaning as that in any one of claims 1-3, and R and Y are preferably substituted or unsubstituted phenyl, further preferably unsubstituted phenyl.

5. A cyanate ester resin composition, comprising the phosphazene compound comprising cyano group of any one of claims 1-3.

6. A prepreg prepared by impregnating a substrate with the cyanate ester resin composition of claim 5 or coating the cyanate ester resin composition of claim 5 onto a substrate;
preferably, the substrate is a glass fiber substrate, a polyester substrate, a polyimide substrate, a ceramic substrate or a carbon fiber substrate.

7. A composite metal laminate, comprising more than one sheet of the prepreg described above and prepared by coating metal layer on the surface of the prepregs, overlapping and pressing successively;
preferably, the material of the surface-coated metal layer is aluminium, copper, iron and alloys of any combination thereof;
preferably, the composite metal laminate are CEM-1 copper-clad laminate, CEM-3 copper-clad laminate, FR-4 copper-clad laminate, FR-5 copper-clad laminate, CEM-1 aluminum-clad laminate, CEM-3 aluminum-clad laminate, FR-4 aluminum-clad laminate or FR-5 aluminum-clad laminate.

8. A wiring board prepared by processing wirings on the surface of the composite metal laminate of claim 7.

9. A flexible copper-clad laminate comprising at least one prepreg of claim 6 and a copper foil overlaying at one side or both sides of the superimposed prepregs.

10. A use of the phosphazene compound comprising cyano group of any one of claims 1-3 in IC package panel, HDI package panel, automotive panel or copper-clad laminate.
